# EUROPEAN PATENT APPLICATION

(11) **EP 1 785 751 A1**
(43) Date of publication of application: **16.05.2007**
(21) Application number: 06123749.1
(22) Date of filing: 09.11.2006
(51) Int. Cl.: G02B 5/08, G21K 1/06, G03F 7/20

(54) **Optical element having multilayer film, and exposure apparatus having the optical element**

(30) Priority: 09.11.2005 JP 2005325306
(71) Applicant: Canon Kabushiki Kaisha, Ohta-Ku, Tokyo 146-8501 (JP)
(72) Inventor: Matsumoto, Seiken, Tokyo Tokyo 146-8501 (JP); Kamiya, Osamu, Tokyo Tokyo 146-8501 (JP); Kanazawa, Hidehiro, Tokyo Tokyo 146-8501 (JP)
(74) Representative: TBK-Patent

(57) **Abstract**

A catoptric optical element includes a multilayer film for improving a reflectance to a light. The multilayer film includes a first lamination structure including plural basic lamination elements, each basic lamination element having two types of materials in each layer, each of the two types of materials having a constant thickness in each basic lamination element, the first lamination structure having a constant periodic length where one periodic length is defined as a thickness of each basic lamination element, and a second lamination structure alternately layering the two types of materials, wherein each of the two types of materials has a non-constant thickness, or the second lamination structure has a non-constant periodic length.

## Description

The present invention relates generally to a catoptric optical element, and more particularly to a structure of a multilayer film usable for an exposure apparatus. The present invention is suitable, for example, for an exposure apparatus that exposes a device, such as a substrate for a semiconductor wafer, and a glass plate for a liquid crystal display ("LCD"), using an extreme ultraviolet ("EUV") light with a wavelength of about 13.5 nm.

In order to meet the recent demands for the fine processing, a projection exposure apparatus, which manufactures a semiconductor device, improves the resolving power through use of the exposure light having a shorter wavelength. Recently, an EUV exposure apparatus is proposed which uses the EUV light with a wavelength between 10 nm and 15 nm, e.g., nearly 13.5 nm. In the EUV light region, the light absorption in the material is so large that the dioptric optical element cannot be used, and the EUV exposure apparatus should use a catoptric optical element, such as a mirror and a reflection mask.

The catoptric optical element typically is a multilayer mirror coated with a multilayer film that enhances the reflectance to a target wavelength. The multilayer mirror has about 40 layers of two types or more materials on a plane substrate. A layered film combination depends upon the wavelength of the EUV light. For example, a typical multilayer film for the wavelength of nearly 13.5 nm is made of a combination of molybdenum (Mo) and silicon (Si).

The thickness of each of Mo and Si is controlled so that the multilayer film has a maximum (or peak) reflectance to the normal incident light, for example, with a wavelength of nearly 13.5 nm. In general, each layer of Mo and Si has a constant thickness in this multilayer film, and the multilayer film is set to have a constant periodic length when one period is defined as the thickness of a lamination structure that consists of one Mo layer and one Si layer.

Prior art include Japanese Patent Applications, Publication Nos. 2001-51106 and S60-7400, and H5-164899, and M. Yamamoto and T. Narioka: Layer-by-Layer Design Method for Soft-x-ray Multilayers, Appl. Phys, Vol 31. No 10/1 April, (1992), 95.

The conventional multilayer film is usually designed to have a peak reflectance to the normal incident light, and an incident angle range for the reflectance of 50% or higher is about 10° to about 12°. Therefore, a desired critical dimension ("CD") is not obtained outside this incident angle range due to the lowered reflectance.

The present invention is directed to an optical element and an exposure apparatus that can maintain a reflectance to the light with a target wavelength in a wide incident angle.

A catoptric optical element according to one aspect of the present invention includes a multilayer film for improving a reflectance to a light, the multilayer film including a first lamination structure including plural basic lamination elements, each basic lamination element having two types of materials in each layer, each of the two types of materials having a constant thickness in each basic lamination element, the first lamination structure having a constant periodic length where one periodic length is defined as a thickness of each basic lamination element, and a second lamination structure alternately layering two types of materials, wherein each of the two types of materials has a non-constant thickness, or the second lamination structure has a non-constant periodic length.

An exposure apparatus according to still another aspect of the present invention includes the above optical element used to expose a mask pattern onto a plate. A device manufacturing method according to still another aspect of the present invention includes exposing a plate using the above exposure apparatus, and developing the plate that has been exposed. Claims for a device fabricating method for performing operations similar to that of the above exposure apparatus cover devices as intermediate and final products. Such devices include semiconductor chips like an LSI and VLSI, CCDs, LCDs, magnetic sensors, thin film magnetic heads, and the like.

Other objects and further features of the present invention will become readily apparent from the following description of the preferred embodiments with reference to accompanying drawings.

FIG. 1 is a schematic block diagram of a film formation apparatus for forming a multilayer film on an optical element according to the present invention.

FIG. 2A is a partially enlarged section of the optical element having the multilayer film according to one aspect of the present invention. FIG. 2B is a partially enlarged section of a variation of the optical element having the multilayer film shown in FIG. 2A.

FIG. 3A is a wavelength reflection characteristic of a comparative example 1. FIG. 3B is an angular reflection characteristic of the comparative example 1.

FIG. 4A is a wavelength reflection characteristic of a comparative example 2. FIG. 4B is an angular reflection characteristic of the comparative example 2.

FIG. 5A is a wavelength reflection characteristic of a first embodiment. FIG. 5B is an angular reflection characteristic of the first embodiment.

FIG. 6A is a wavelength reflection characteristic when the lamination structure is solely formed on the first embodiment, and FIG. 6B is an angular reflection characteristic in that case.

FIG. 7A is a wavelength reflection characteristic of a second embodiment. FIG. 7B is an angular reflection characteristic of the second embodiment.

FIG. 8A is a wavelength reflection characteristic of a third embodiment. FIG. 8B is an angular reflection characteristic of the third embodiment.

FIG. 9A is a wavelength reflection characteristic of a fourth embodiment. FIG. 9B is an angular reflection characteristic of the fourth embodiment.

FIG. 10A is a wavelength reflection characteristic of a fifth embodiment. FIG. 10B is an angular reflection characteristic of the fifth embodiment.

FIG. 11A is a wavelength reflection characteristic of a sixth embodiment. FIG. 11B is an angular reflection characteristic of the sixth embodiment.

FIG. 12A is a wavelength reflection characteristic of a second embodiment. FIG. 12B is an angular reflection characteristic of the second embodiment.

FIG. 13A is a wavelength reflection characteristic of an eighth embodiment. FIG. 13B is an angular reflection characteristic of the eighth embodiment.

FIG. 14A is a wavelength reflection characteristic of a ninth embodiment. FIG. 14B is an angular reflection characteristic of the ninth embodiment.

FIG. 15A is a wavelength reflection characteristic of a tenth embodiment. FIG. 15B is an angular reflection characteristic of the tenth embodiment.

FIG. 16 is a schematic sectional view of an exposure apparatus to which the inventive optical element is applicable.

FIG. 17 is a flowchart for explaining a device manufacturing method using the inventive exposure apparatus.

FIG. 18 is a detailed flowchart of a wafer process as Step 4 shown in FIG. 17.

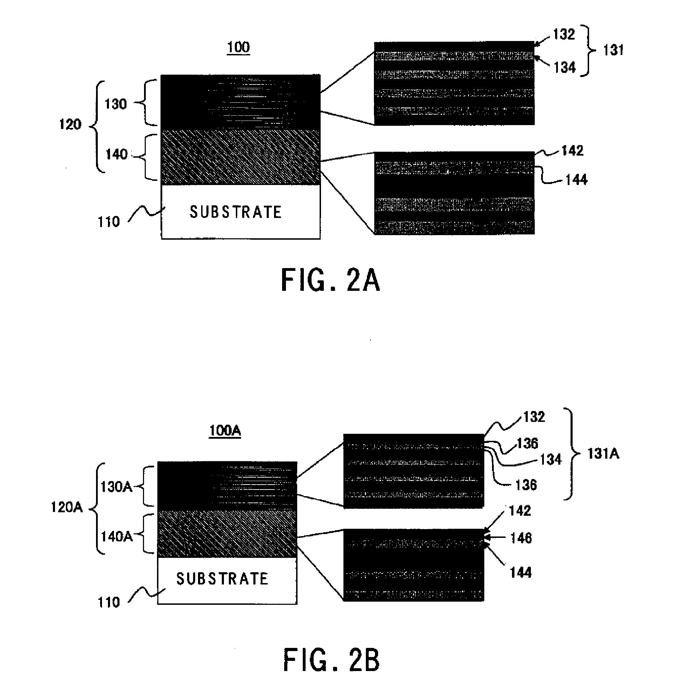

Referring now to FIG. 2A, a description will be given of an optical element having a multilayer film according to one aspect of the present invention. Here, FIG. 2A is a partially enlarged section of the optical element 100. The optical element 100 is a catoptric optical element in which a multilayer film 120 that improves the light reflectance is formed on a substrate 110.

The multilayer film 120 includes a pair of lamination structures 130 and 140.

The lamination structure 130 has a reflection characteristic that provides a maximum reflectance to the normal incident light with a target wavelength, and maintains the maximum reflectance in the incident angle range between about 10° and about 12°. This embodiment sets the target wavelength to 13.5 nm. The lamination structure 130 stacks plural basic lamination elements 131, each of which includes a Si layer 132 and a Mo layer 134. In the basic lamination element 131, each of the Si layer 132 and the Mo layer 134 has a constant thickness. When one period is defined as a total thickness of the basic lamination element 131, the lamination structure 130 has a constant periodic length. The lamination structure 130 may contain, as in the third and sixth embodiments, which will be described later, two or more lamination structures having different periodic lengths, such as 130B and 130C.

The lamination structure 140 has a reflection characteristic that provides a predetermined reflectance to the light having the wavelength 13.5 nm and incident in a wider incident angle range than that of the lamination structure 130 when combined with the reflection characteristic of the lamination structure 130. The reflection characteristic of the lamination structure 140 provides a maximum reflectance and a minimum reflectance at a wavelength different from the target wavelength. The lamination structure 140 has a lamination structure that alternately laminates a Si layer 142 and a Mo layer 144. In this lamination structure, the Si layer 142 and the Mo layer 144 do not have a constant thickness and/or the lamination structure 140 does not have a constant thickness.

In FIG. 2A, Si and Mo are used for a film material, because they are universally used for the multilayer mirror's component material in the EUV lithography. Both of the light reflectance value and the light incident angle range relate to a complex refractive index (refractive index and extinction coefficient) of a material that receives the light. For production purposes, a multilayer mirror having a high reflectance and a wide light incident angle range should use materials having a large difference of the refractive index and small light absorptions. Laminations of Si and Mo with a constant periodic length would provide a high reflectance, but would not provide a multilayer mirror having a wide light incident angle range. The laminations of Si and Mo with non-constant periodic lengths would provide a multilayer mirror that can reflect the light at a high incident angle. In addition, since the lamination structure 130 is arranged on the front surface (or light incident) side of the multilayer film 120 opposite to the substrate 110, the central wavelength of the peak reflectance can be determined.

Since the film material varies when the target wavelength varies, two types of materials are not limited to Si and Mo. For example, the materials may use beryllium (Be) and Mo for the light having a wavelength of nearly 11 nm.

In addition, as shown in FIG. 2B, the multilayer film may have an additional layer between the Si layer 132 (or 142) and the Mo layer 134 (or 144). Here, FIG. 2B is a partially enlarged sectional view of the optical element 100A as a variation of the optical element 100. The material between the Si layer 132 (or 142) and the Mo layer 134 (or 144) may have a primary ingredient selected from B, C, Ru, Rh, Li, Pd and a compound of these material. In FIG. 2B, the multilayer film has lamination structures 130A and 140A. The lamination structure 130A has a basic lamination element 131A that includes a Si layer 132, an intermediate layer 136, an Mo layer 134, and the intermediate layer 136. The lamination structure 140A has a Si layer 142, an intermediate layer 146, a Mo layer 144, and the intermediate layer 146. The intermediate layer 136 is not restricted in type, the number of layers, and switching spot, and the alternating order is not necessarily the same order. The intermediate layers 136 and 146 have an effect of preventing a contact and a composite layer between Si and Mo. This problem can be solved by widening the incident angle range and by combining the lamination structure 130A having a constant periodic length with the lamination structure 140A having a non-constant periodic length.

### COMPARATIVE EXAMPLE 1

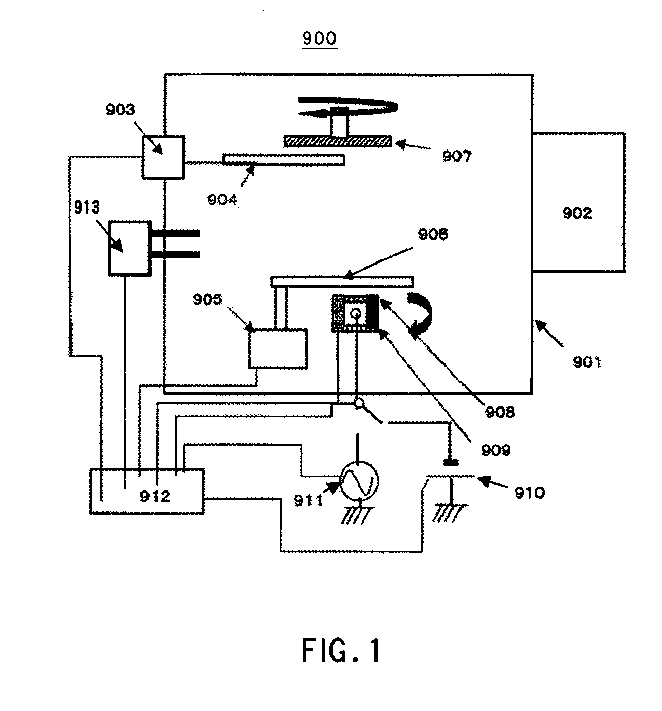

A produced multilayer mirror has a constant film thickness as a whole, a distribution Bragg reflection structure similar to the 1/4 wavelength lamination structure, and a peak wavelength of 13.5 nm at an incident angle of 0°. FIG. 1 is a block diagram of a sputtering film formation apparatus 900. The film formation apparatus 900 includes a vacuum chamber 901, a vacuum pump 902, a movable mask 904, a shutter 906, a substrate and rotating mechanism 907, various targets 908 and 909, and a control system. The vacuum pump 902 maintains a vacuum or decompression environment in the vacuum chamber 901, and the vacuum chamber 901 stores each component. The control system includes a mask movement controller 903, a shutter controller 905, a DC power source 910, an RF power source, and an Ar gas introduction controller 913, and is connected to and totally controlled by a control computer 912.

Ru and B4C targets (not shown) may be attached in addition to a 4-inch-diameter B-doped polycrystalline Si target 908 and an Mo target 909. When the target rotates to switch each material, and forms a film on the substrate. The target material may be exchanged.

The substrate 907 is made of silicon with a diameter of 500 mm, and a thickness of 300 µm, and rotates during film formation. Provided between the substrate 907 and the target are the shutter 906 whose opening and closing are controlled by the shutter controller 905, and the movable mask 904 that is controlled by the mask movement controller 903 and controls a film thickness distribution on the substrate. During the film formation, the Ar gas introduction controller 913 introduces the Ar gas by 30 sccm. The DC power source 910 maintains predetermined power projected to the target, and the RF power source 911 uses the RF high frequency 150W of 13.56 MHz. The computer 912 time-controls the thickness of each layer.

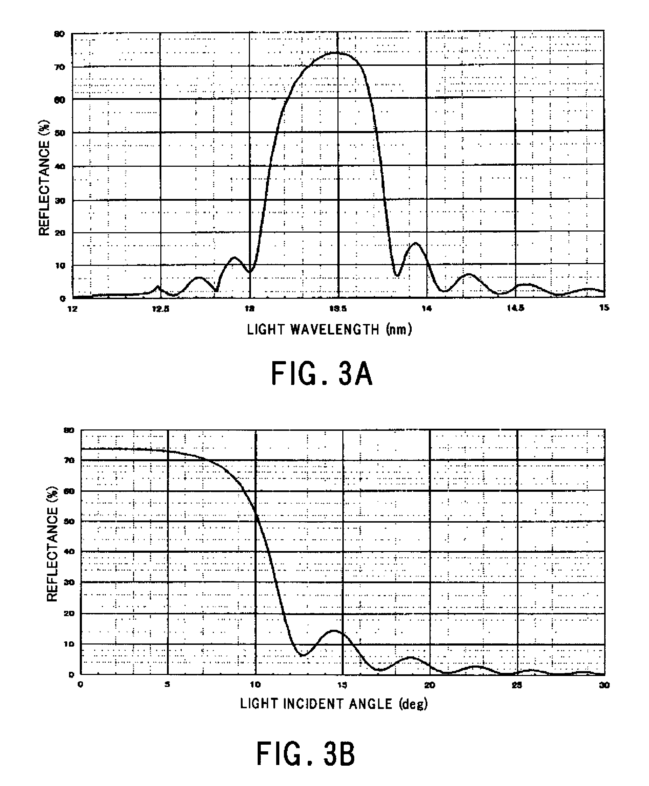

The multilayer mirror has 40 Mo/Si alternate layers. When it is designed so that the peak wavelength is 13.5 nm to the incident angle of 0°, the thickness of Si is 4.3 nm, and the thickness of Mo is 2.6 nm. The film formation time periods are 43 seconds and 13 seconds, respectively. The film formation time data is input to the computer 912. FIG. 3A is a wavelength reflection characteristic of a thus formed multilayer mirror, and FIG. 3B is an angular reflection characteristic, where the multilayer mirror has a peak wavelength of 13.5 nm to the light at the incident angle of 0°. A wave range for the reflectance of 50% or greater is between 13.2 nm and 13.7 nm. An angular range for the reflectance of 50% or greater is between 0° and 10°.

### COMPARATIVE EXAMPLE 2

A multilayer mirror produced by the sputtering film formation apparatus 900 has a constant film thickness as a whole, a distribution Bragg reflection structure similar to the 1/4 wavelength lamination structure, and a peak wavelength of 13.5 nm at an incident angle of 0°. This embodiment is different from the comparative example 1 in that Ru and B4C targets (not shown) are attached in addition to a 4-inch-diameter B-doped polycrystalline Si target 908 and an Mo target 909.

The multilayer mirror has 40 Si/Mo alternate layers (comparative example A), 40 Si/B4C/Mo alternate layers (comparative example B), and 40 Si/Ru/Mo alternate layers (comparative example C). It is designed so that the peak wavelength is 13.5 nm to the incident angle of 0°. In the comparative example A, the thickness of Si is 4.12 nm, and the thickness of Mo is 2.85 nm. The film formation time periods are 41 seconds and 14 seconds, respectively. In the comparative example B, the thickness of Si is 3.55 nm, the thickness of Mo is 2.37 nm, and the thickness of BC4 is 0.5 nm. The film formation time periods are 36 seconds, 12 seconds, and 125 seconds, respectively. In the comparative example C, the thickness of Si is 4.16 nm, the thickness of Mo is 1.68 nm, and the thickness of Ru is 1.07 nm. The film formation time periods are 42 seconds, 8 seconds, and 5 seconds, respectively. The film formation time data is input to the computer 912.

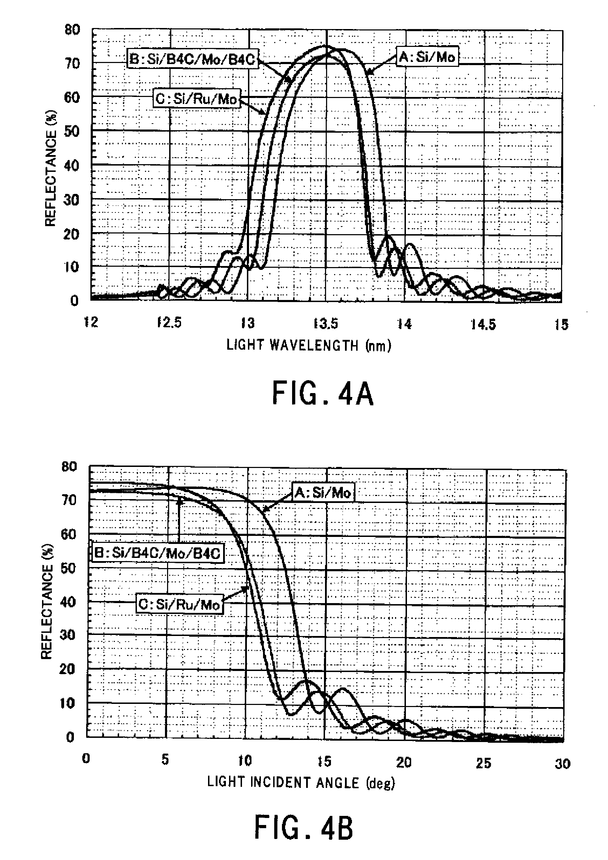

FIG. 4A is a wavelength reflection characteristic of a multilayer mirror, and FIG. 4B is an angular reflection characteristic, where the multilayer mirror has a peak wavelength of 13.5 nm to the light at the incident angle of 0°. A wave range having a reflectance of 50% or higher is between 13.3 nm and 13.8 nm in the comparative example A, between 13.2 nm and 13.7 nm in the comparative example B, and between 13.1 nm and 13.7 nm in the comparative example C. An angular range having a reflectance of 50% or higher is between 0° and 12° in the comparative example A, between 0° and 10° in the comparative example B, and between 0° and 9° in the comparative example C. It is understood from these comparative examples that a reflectable wave range and angular range decrease when a different material is sandwiched between the alternative layers of the first and second materials.

### FIRST EMBODIMENT

A multilayer mirror is produced in a similar manner to the comparative example 1 so that the peak wavelength is 13.5 nm to the incident angle of 0°. The multilayer film 120 has 61 layers that include the lamination structure 140 having 36 layers on the substrate 110, the lamination structure 130 having 24 layers on the lamination structure 140, and a Si cap layer on the lamination structure 130. Table 1 indicates details of each film thickness, and the film formation time period. The film formation time data is input in the computer 912.

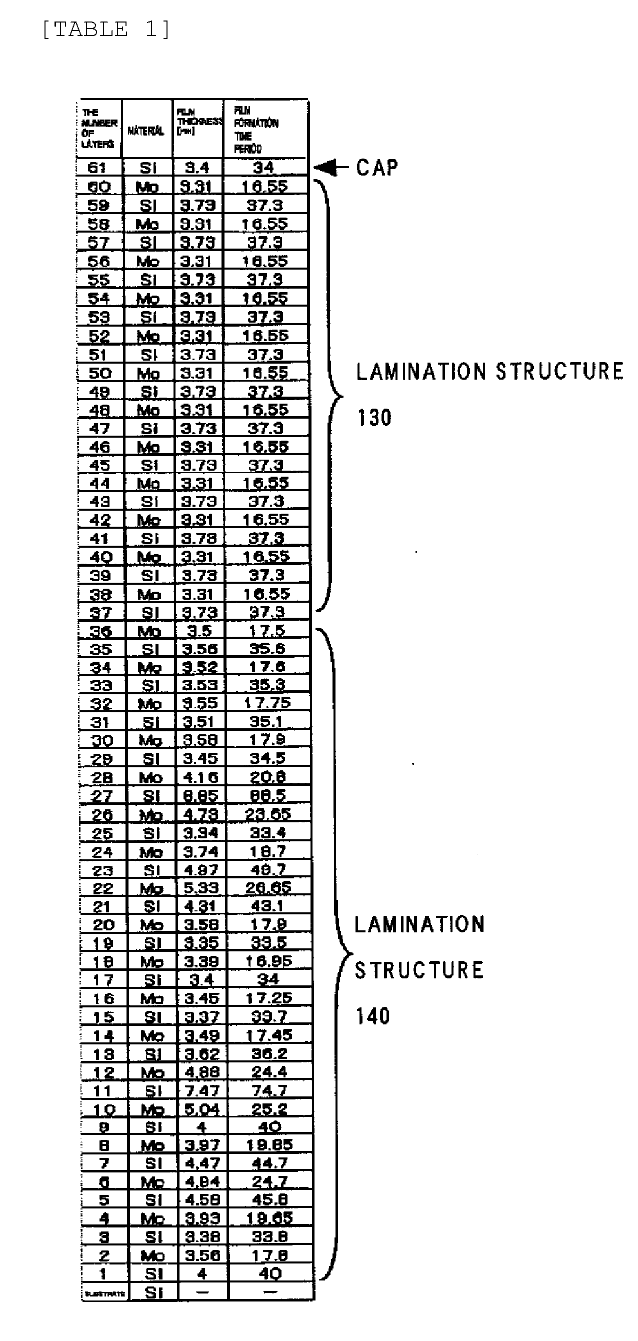

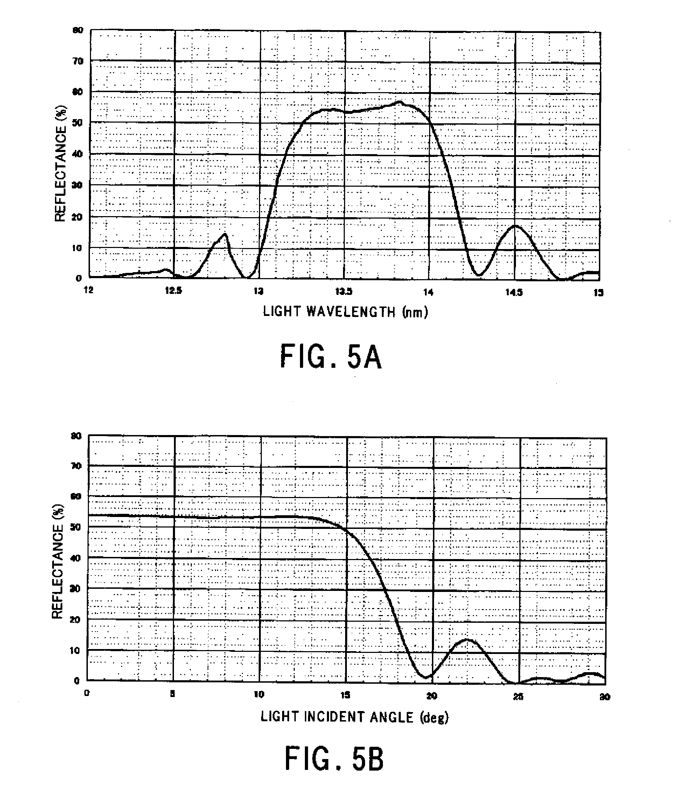

FIG. 2A is a schematic view of the thus produced multilayer mirror. FIG. 5A shows a wavelength reflection characteristic. FIG. 5B shows an angular reflection characteristic. The reflectance is maintained 50% or greater in a wave range between 13.3 nm and 14.0 nm and up to an incident angle of 14°. It is understood from FIG. 5A that the wave range that provides the reflectance of 50% or greater increases by 0.2 nm in comparison with FIG. 3A. It is understood from FIG. 5B that the angular range that provides the reflectance of 50% or greater increases by 4° in comparison with FIG. 3B.

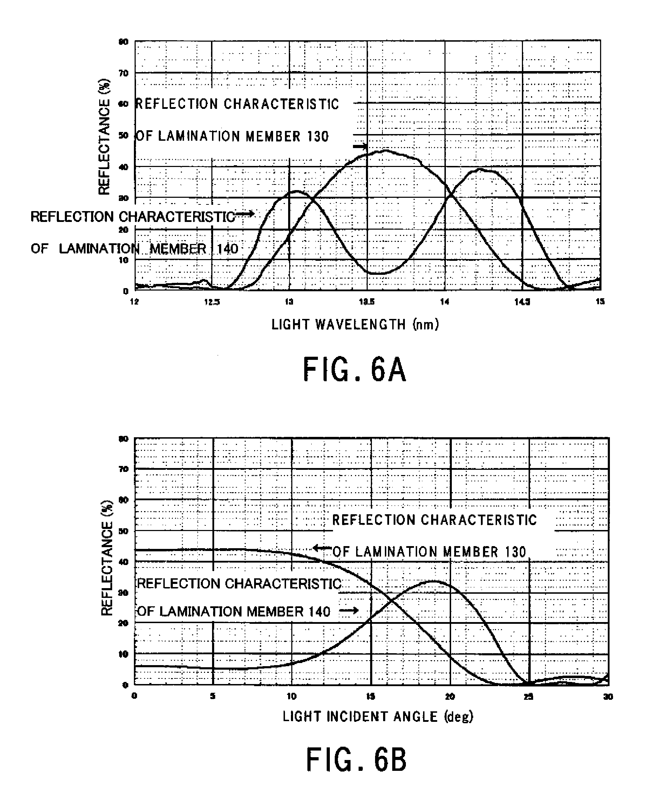

FIGs. 6A and 6B are a wavelength reflection characteristic and an angular reflection characteristic of the multilayer mirror when the lamination structures 130 and 140 are solely formed. As shown in FIG. 6A, when the reflection characteristic of the lamination structure 130 and the reflection characteristic of the lamination structure 140 are synthesized, the reflection characteristic shown FIG. 5A is obtained. The reflection characteristic of the lamination structure 130 has a peak at the wavelength of nearly 13.5 nm, and the reflection characteristic of the lamination structure 140 has a peak at the wavelength other than 13.5 nm. As shown in FIG. 6B, when the reflection characteristic of the lamination structure 130 and the reflection characteristic of the lamination structure 140 are synthesized, the reflection characteristic shown FIG. 5B is obtained. The reflection characteristic of the lamination structure 130 has a constant reflectance between 0° and 10°, and the reflection characteristic of the lamination structure 140 has a reflection peak at a high incident angle of 19°.

While the film formation uses sputtering, the manufacturing method is not limited to this method. For example, the evaporation method may be used. This applies to the following embodiments.

### SECOND EMBODIMENT

A multilayer mirror is produced in a similar manner to the comparative example 1 so that the peak wavelength is 13.5 nm to the incident angle of 0°. The multilayer film 120 has 51 layers that include the lamination structure 140 having 10 layers on the substrate 110, the lamination structure 130 having 40 layers on the lamination structure 140, and a Si cap layer on the lamination structure 130. While the number of layers in the lamination structure 140 is greater than that of the lamination structure 130 in the first embodiment, the number of layers in the lamination structure 130 is greater than that of the lamination structure 140 in this embodiment. Table 2 indicates details of each film thickness, and the film formation time period. The film formation time data is input in the computer 912.

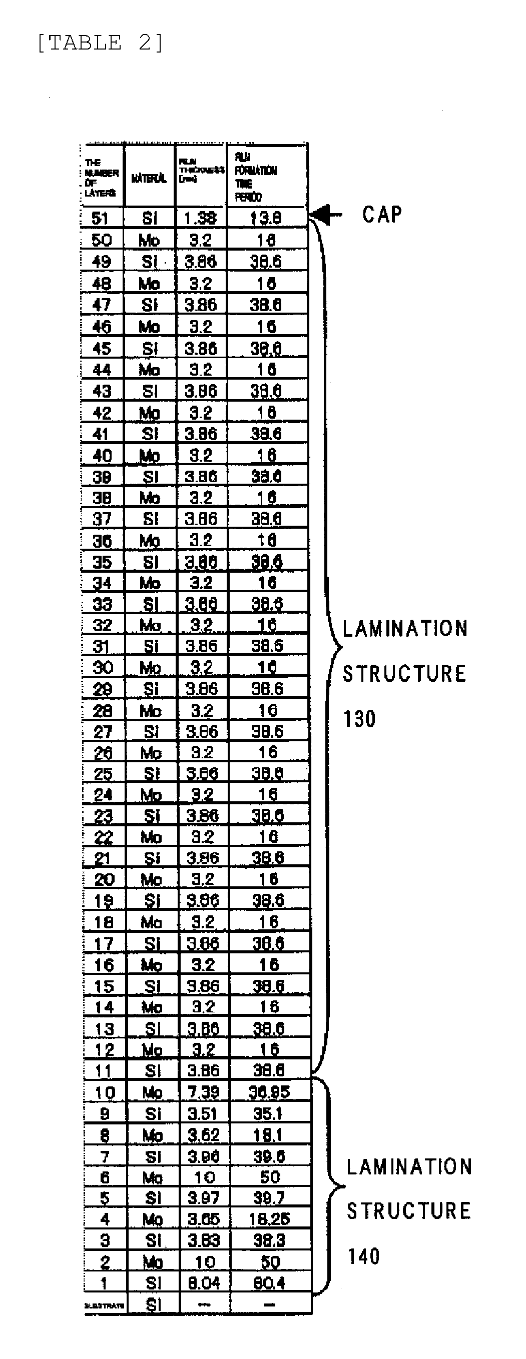

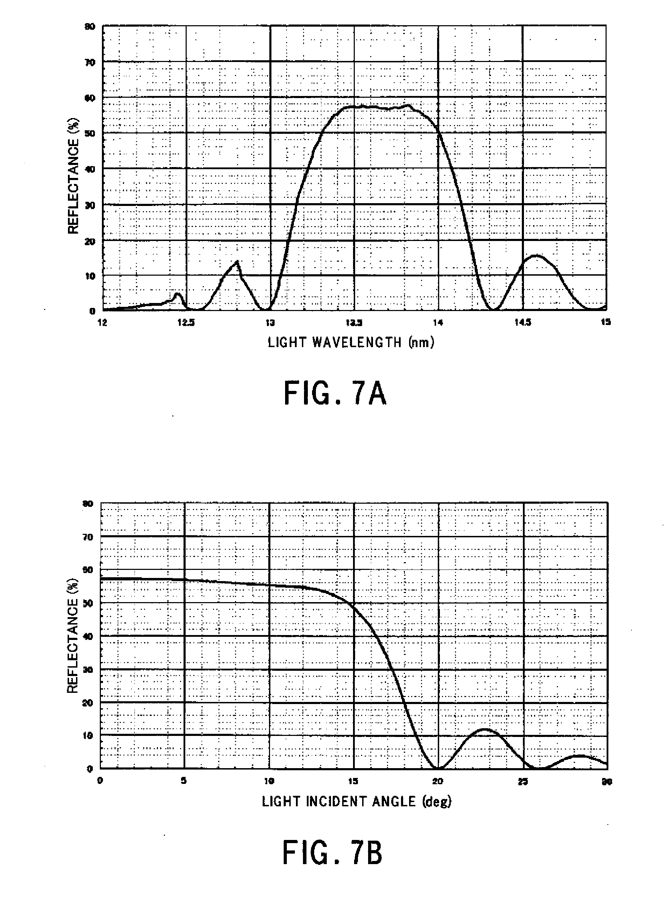

FIG. 2A is a schematic view of the thus produced multilayer mirror. FIG. 7A shows a wavelength reflection characteristic. FIG. 7B shows an angular reflection characteristic. The reflectance is maintained 50% or greater in a wave range between 13.3 nm and 14.0 nm and up to an incident angle of 14°. It is understood from FIG. 7A that the wave range that provides the reflectance of 50% or greater increases by 0.2 nm in comparison with FIG. 3A. It is understood from FIG. 5B that the angular range that provides the reflectance of 50% or greater increases by 4° in comparison with FIG. 3B.

### THIRD EMBODIMENT

A multilayer mirror is produced in a similar manner to the comparative example 1 so that the peak wavelength is 13.5 nm to the incident angle of 0°. The multilayer film 120 has 51 layers that include the lamination structure 140 having 10 layers on the substrate 110, the lamination structure 130B having 20 layers on the lamination structure 140, the lamination structure 130C having a different periodic length and 20 layers on the lamination structure 130B, and a Si cap layer on the lamination structure 130. Table 3 indicates details of each film thickness, and the film formation time period. 40 layers having a constant periodic length in the second example are divided into the lamination structures 130B and 130C each with 20 layers having two types of periodic lengths. The film formation time data is input in the computer 912.

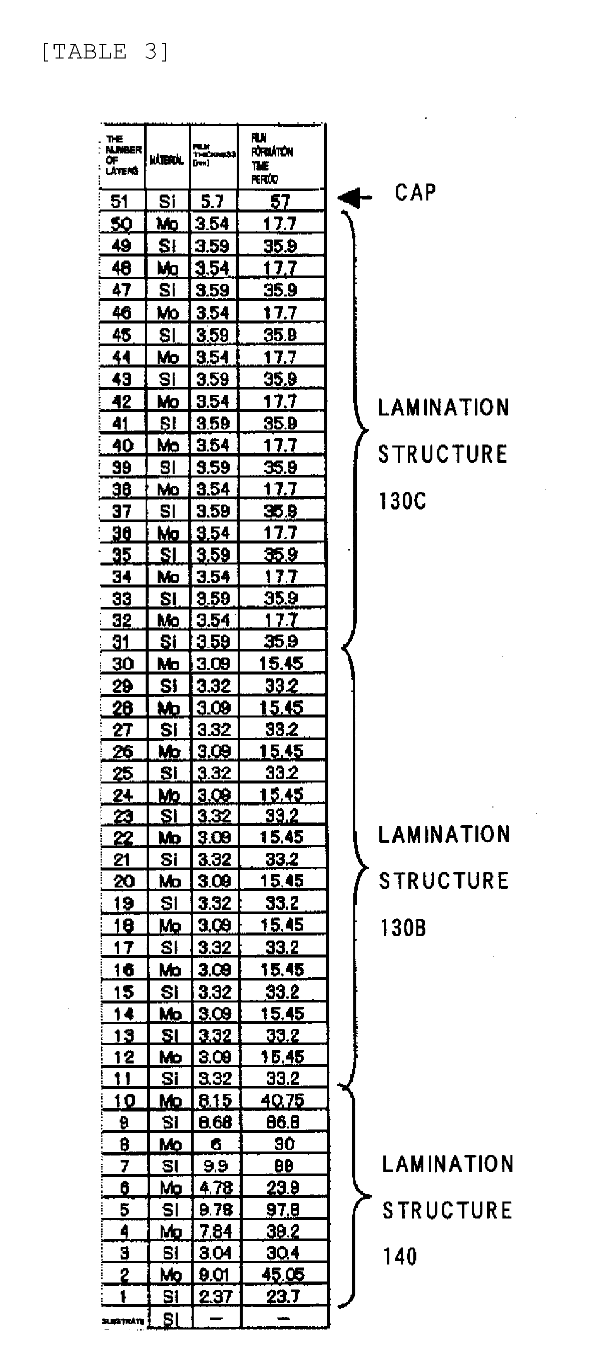

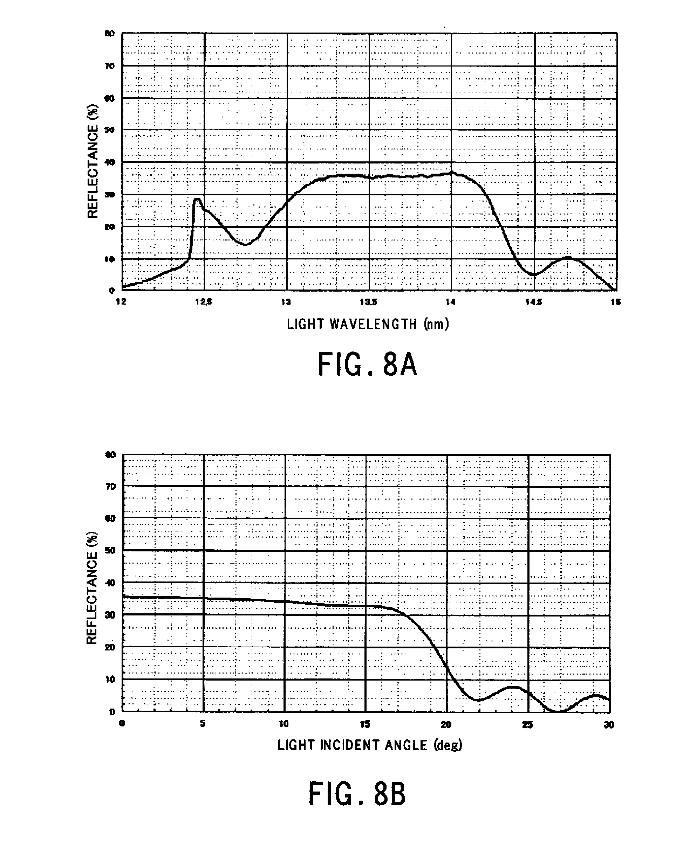

FIG. 2A is a schematic view of the thus produced multilayer mirror. FIG. 8A shows a wavelength reflection characteristic. FIG. 8B shows an angular reflection characteristic. The reflectance is maintained 30% or greater in a wave range between 13.1 nm and 14.2 nm and up to an incident angle of 17°. It is understood from FIG. 8A that the wave range that provides the reflectance of 30% or greater increases by 0.5 nm in comparison with FIG. 3A. It is understood from FIG. 8B that the angular range that provides the reflectance of 30% or greater increases by 6° in comparison with FIG. 3B. This embodiment causes lower reflectance than the second embodiment, but provides a higher light incident angle.

### FOURTH EMBODIMENT

A multilayer mirror is produced in a similar manner to the comparative example 1 so that the peak wavelength is 13.5 nm to the incident angle of 0°. The multilayer film 120 has 61 layers that include the lamination structure 130 having 20 layers on the substrate 110, the lamination structure 140 having 40 layers on the lamination structure 130, and a Si cap layer on the lamination structure 140. Table 4 indicates details of each film thickness, and the film formation time period. The film formation time data is input in the computer 912.

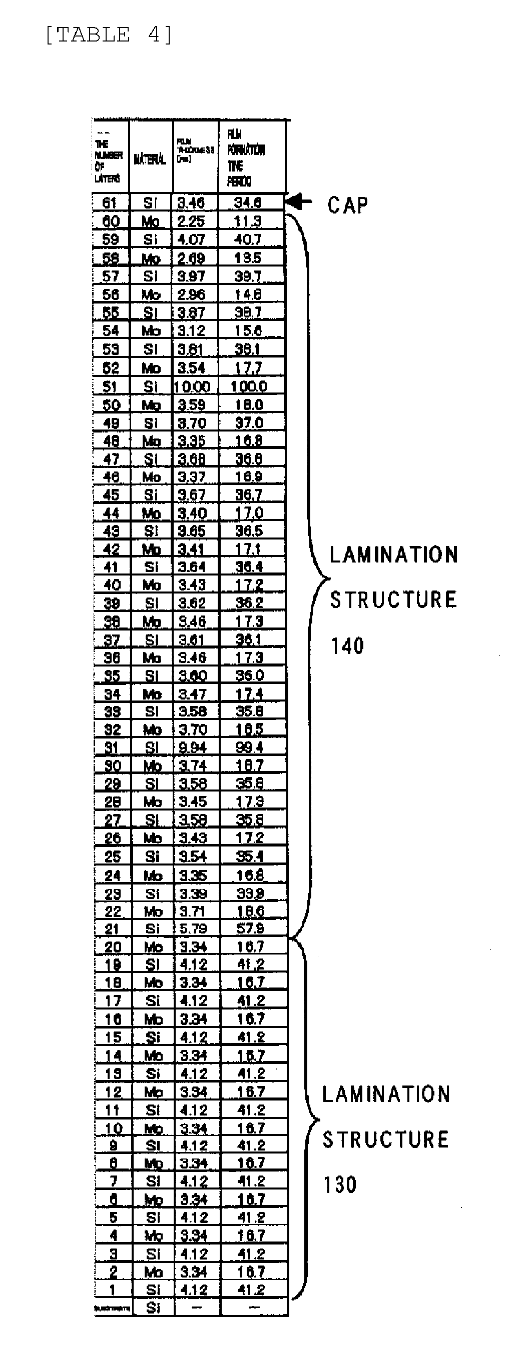

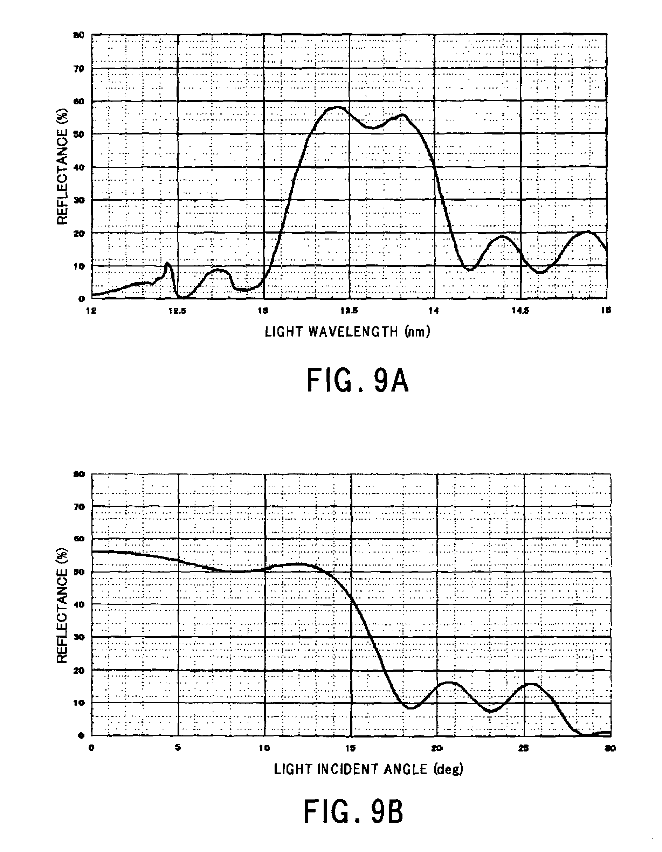

FIG. 2A is a schematic view of the thus produced multilayer mirror. FIG. 9A shows a wavelength reflection characteristic. FIG. 9B shows an angular reflection characteristic. The reflectance is maintained 50% or greater in a wave range between 13.3 nm and 13.9 nm and up to an incident angle of 13°. This embodiment is not so good as the first and second embodiments, but is effective to widen the light incident angle range. It is understood from FIG. 9A that the wave range that provides the reflectance of 50% or greater increases by 0.1 nm in comparison with FIG. 3A. It is understood from FIG. 9B that the angular range that provides the reflectance of 50% or greater increases by 3° in comparison with FIG. 3B.

### FIFTH EMBODIMENT

A multilayer mirror is produced in a similar manner to the comparative example 1 so that the peak wavelength is 13.5 nm to the incident angle of 0°. The multilayer film 120 has 61 layers that include the lamination structure 140 having 20 layers on the substrate 110, the lamination structure 130 having 20 layers on the lamination structure 140, the lamination structure 140 having 20 layers on the lamination structure 130, and a Si cap layer on the lamination structure 140. Table 5 indicates details of each film thickness, and the film formation time period. The film formation time data is input in the computer 912.

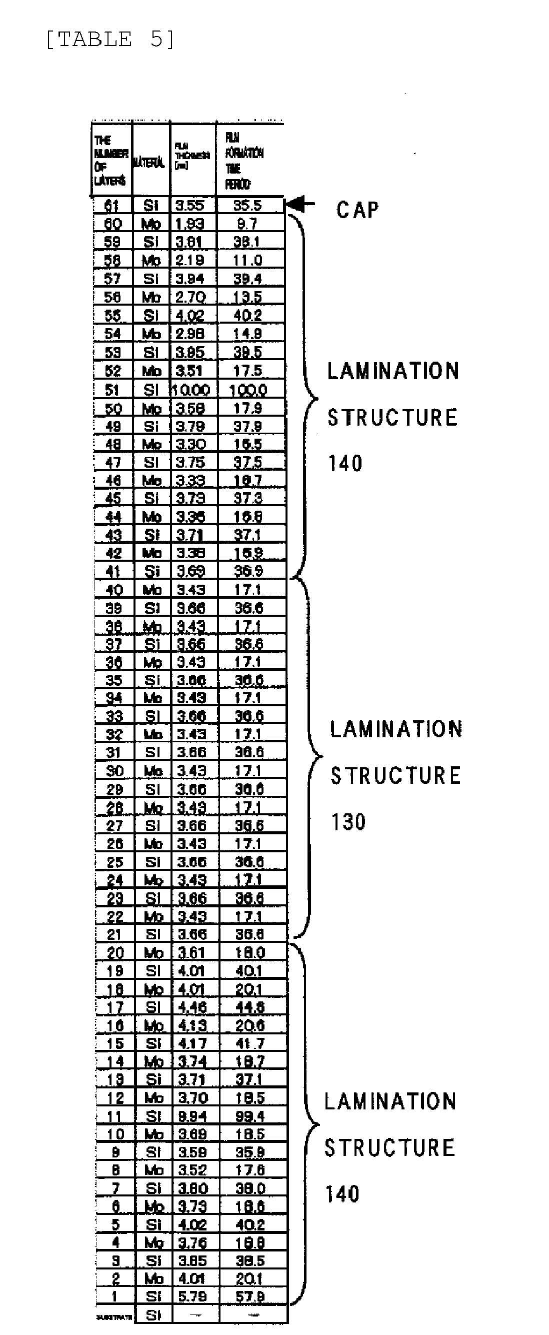

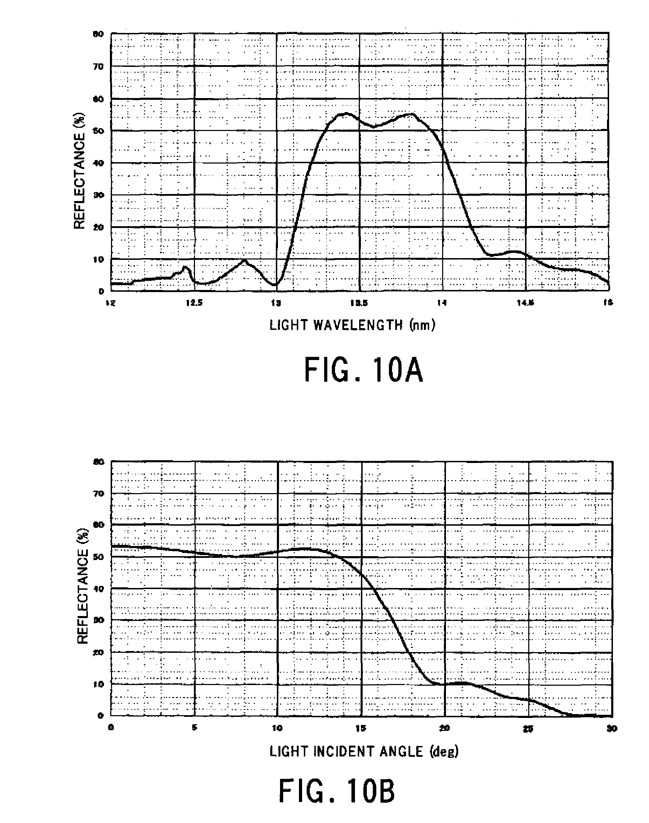

FIG. 2A is a schematic view of the thus produced multilayer mirror. FIG. 10A shows a wavelength reflection characteristic. FIG. 10B shows an angular reflection characteristic. The reflectance is maintained 50% or greater in a wave range between 13.3 nm and 13.9 nm and up to an incident angle of 13°. This embodiment is not so good as the first and second embodiments, but is effective to widen the light incident angle range. It is understood from FIG. 10A that the wave range that provides the reflectance of 50% or greater increases by 0.1 nm in comparison with FIG. 3A. It is understood from FIG. 10B that the angular range that provides the reflectance of 50% or greater increases by 3° in comparison with FIG. 3B.

### SIXTH EMBODIMENT

A multilayer mirror is produced in a similar manner to the comparative example 1 so that the peak wavelength is 13.5 nm to the incident angle of 0°. The multilayer film 120 has 61 layers that include the lamination structure 130B having 20 layers on the substrate 110, the lamination structure 140 having 10 layers on the lamination structure 130B, the lamination structure 130C having a different periodic length and 20 layers on the lamination structure 140, the lamination structure 140 having 10 layers on the lamination structure 130C, and a Si cap layer on the lamination structure 140. Table 6 indicates details of each film thickness, and the film formation time period. The film formation time data is input in the computer 912.

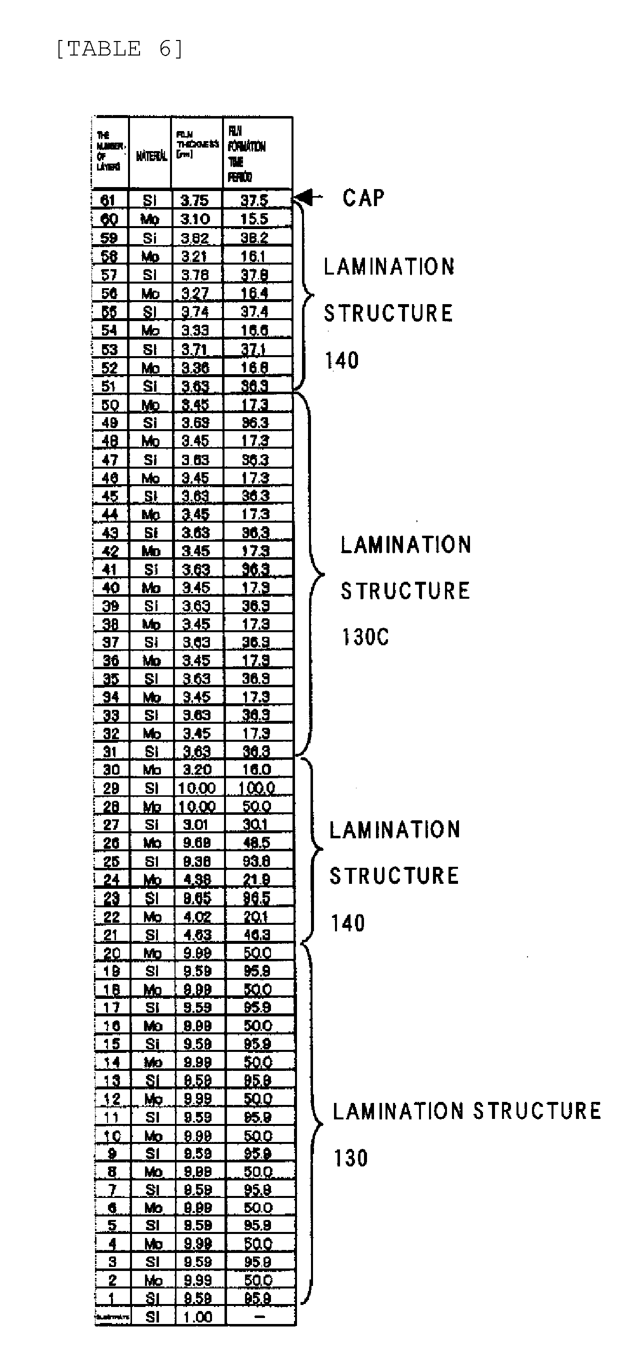

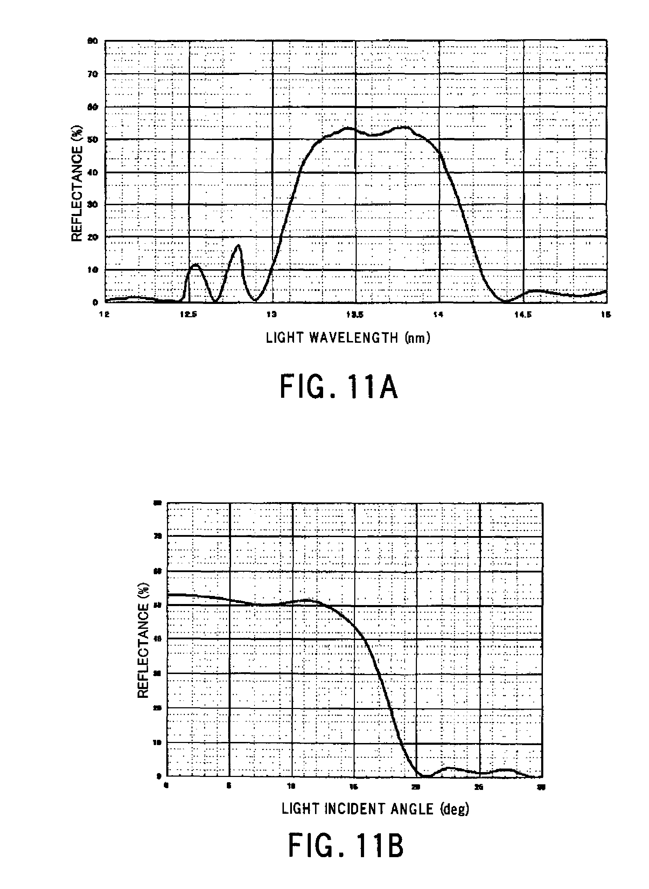

FIG. 2A is a schematic view of the thus produced multilayer mirror. FIG. 11A shows a wavelength reflection characteristic. FIG. 11B shows an angular reflection characteristic. The reflectance is maintained 50% or greater in a wave range between 13.3 nm and 13.9 nm and up to an incident angle of 12°. This embodiment is not so good as the first and second embodiments, but is effective to widen the light incident angle range. It is understood from FIG. 11A that the wave range that provides the reflectance of 50% or greater increases by 0.1 nm in comparison with FIG. 3A. It is understood from FIG. 11B that the angular range that provides the reflectance of 50% or greater increases by 2° in comparison with FIG. 3B.

### SEVENTH EMBODIMENT

A multilayer mirror is produced in a similar manner to the comparative example 2 so that the peak wavelength is 13.5 nm to the incident angle of 0°. The multilayer film 120A has 121 layers that include the lamination structure 140A having 72 layers on the substrate 110, the lamination structure 130A having 48 layers on the lamination structure 140A, and a Si cap layer on the lamination structure 130A. Table 7 indicates details of each film thickness, and the film formation time period. The film thickness ranges are preferably 0.5 nm ≤ Si ≤ 10 nm, 0.5 nm ≤ Mo ≤ 10 nm, and 0.1 nm ≤ B4C ≤ 2 nm. The film formation time data is input in the computer 912.

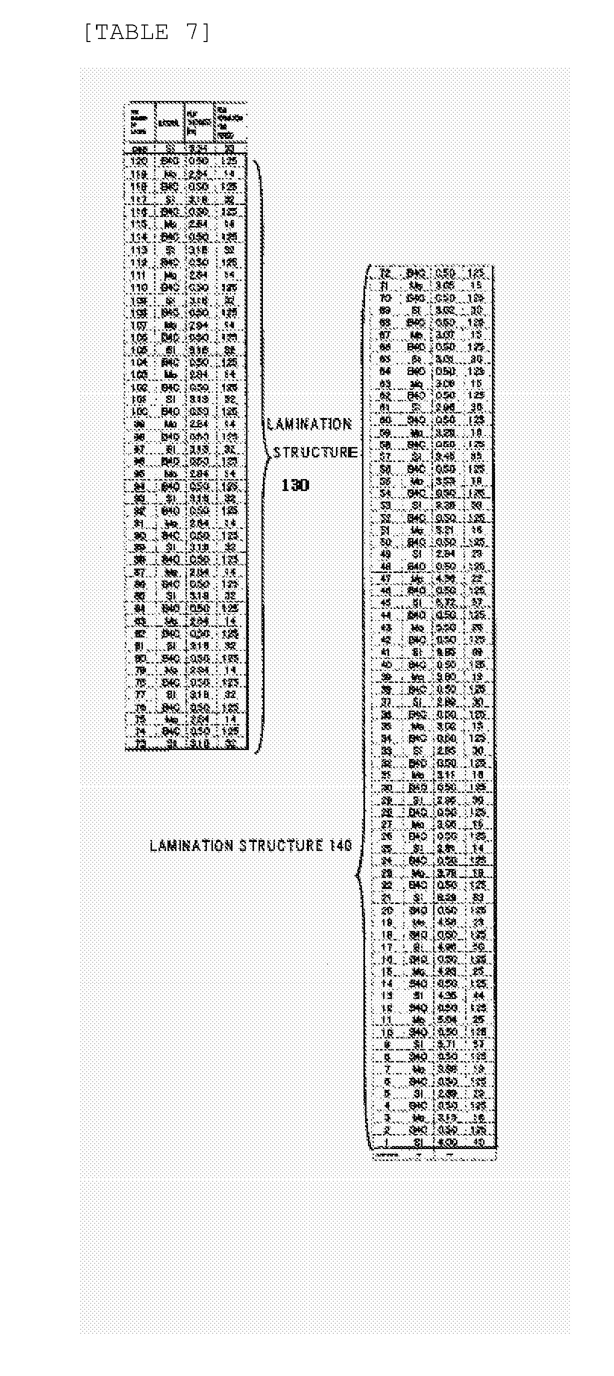

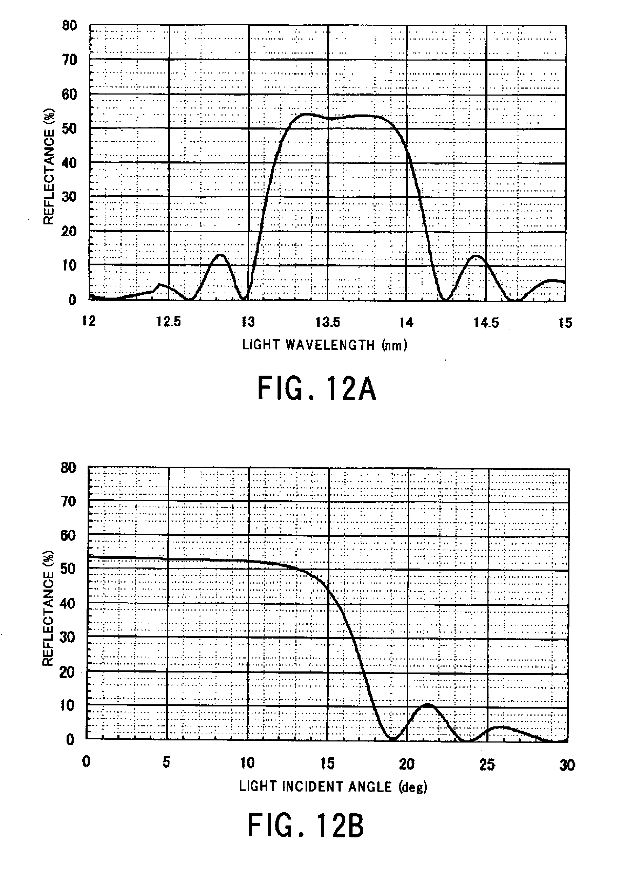

FIG. 2B is a schematic view of the multilayer mirror. FIG. 12A shows a wavelength reflection characteristic. FIG. 12B shows an angular reflection characteristic. The reflectance is good enough to maintain 50% or greater in a wave range between 13.3 nm and 13.9 nm and up to an incident angle of 13°. It is understood from FIG. 12A that the wave range that provides the reflectance of 50% or greater increases by 0.1 nm in comparison with B in FIG. 4A. It is understood from FIG. 12B that the angular range that provides the reflectance of 50% or greater increases by 3° in comparison with B in FIG. 4B.

### EIGHTH EMBODIMENT

A multilayer mirror is produced in a similar manner to the comparative example 2 so that the peak wavelength is 13.5 nm to the incident angle of 0°. The multilayer film 120A has 101 layers that include the lamination structure 130A having 20 layers on the substrate 110, the lamination structure 140A having 80 layers on the lamination structure 130A, and a Si cap layer on the lamination structure 140A. While the number of layers in the lamination structure 140A is greater than that of the lamination structure 130A in the seventh embodiment, the number of layers in the lamination structure 130A is greater than that of the lamination structure 140A in this embodiment. Table 8 indicates details of each film thickness, and the film formation time period. The film thickness ranges are preferably 0.5 nm ≤ Si ≤ 10 nm, 0.5 nm ≤ Mo ≤ 10 nm, and 0.1 nm ≤ B4C ≤ 2 nm. The film formation time data is input in the computer 912.

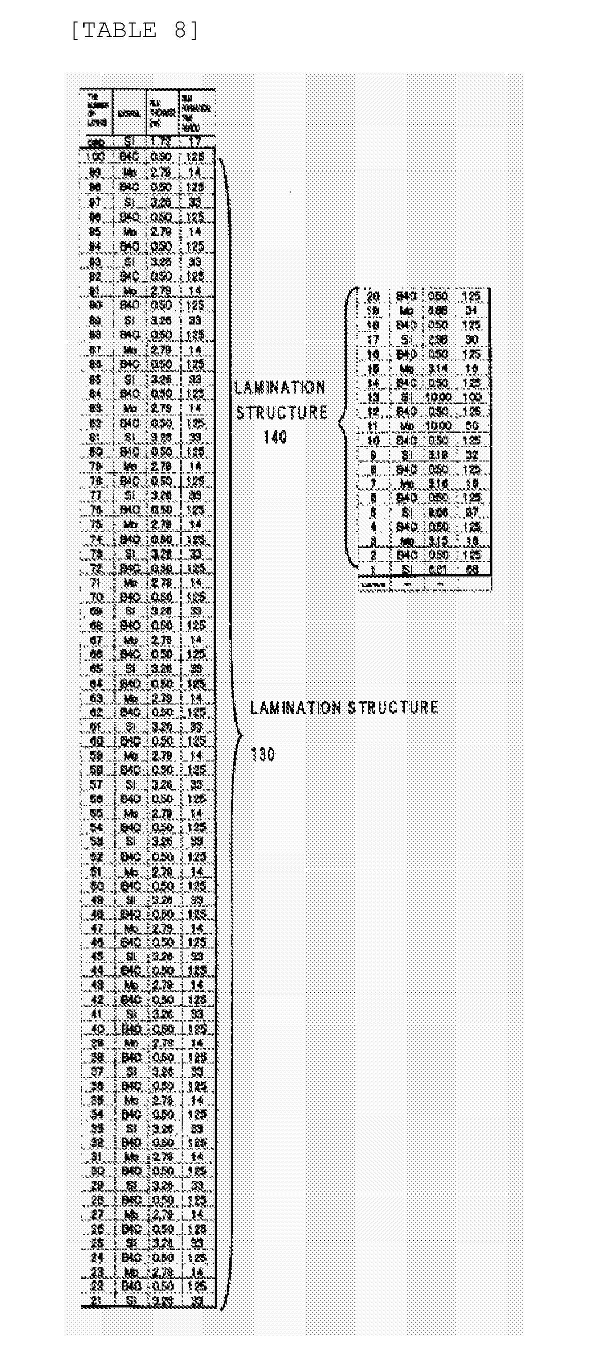

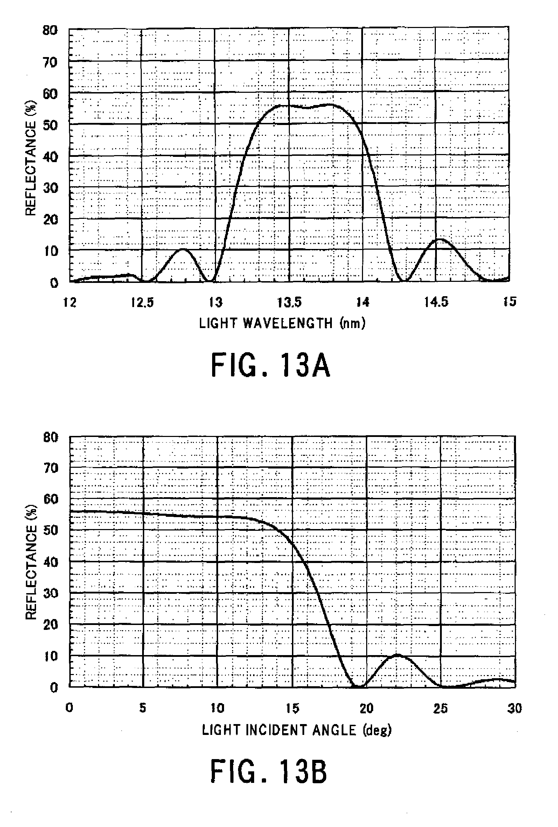

FIG. 2B is a schematic view of the multilayer mirror. FIG. 13A shows a wavelength reflection characteristic. FIG. 13B shows an angular reflection characteristic. The reflectance is good enough to maintain 50% or greater in a wave range between 13.3 nm and 13.9 nm and up to an incident angle of 14°. It is understood from FIG. 13A that the wave range that provides the reflectance of 50% or greater increases by 0.1 nm in comparison with B in FIG. 4A. It is understood from FIG. 13B that the angular range that provides the reflectance of 50% or greater increases by 4° in comparison with B in FIG. 4B.

### NINTH EMBODIMENT

A multilayer mirror is produced in a similar manner to the comparative example 2 so that the peak wavelength is 13.5 nm to the incident angle of 0°. The multilayer film 120A has 91 layers that include the lamination structure 140A having 54 layers on the substrate 110, the lamination structure 130A having 36 layers on the lamination structure 140A, and a Si cap layer on the lamination structure 130A. Table 9 indicates details of each film thickness, and the film formation time period. The film thickness ranges are preferably 0.5 nm ≤ Si ≤ 10 nm, 0.5 nm ≤ Mo ≤ 10 nm, and 0.5 nm ≤ Ru ≤ 10 nm. The film formation time data is input in the computer 912.

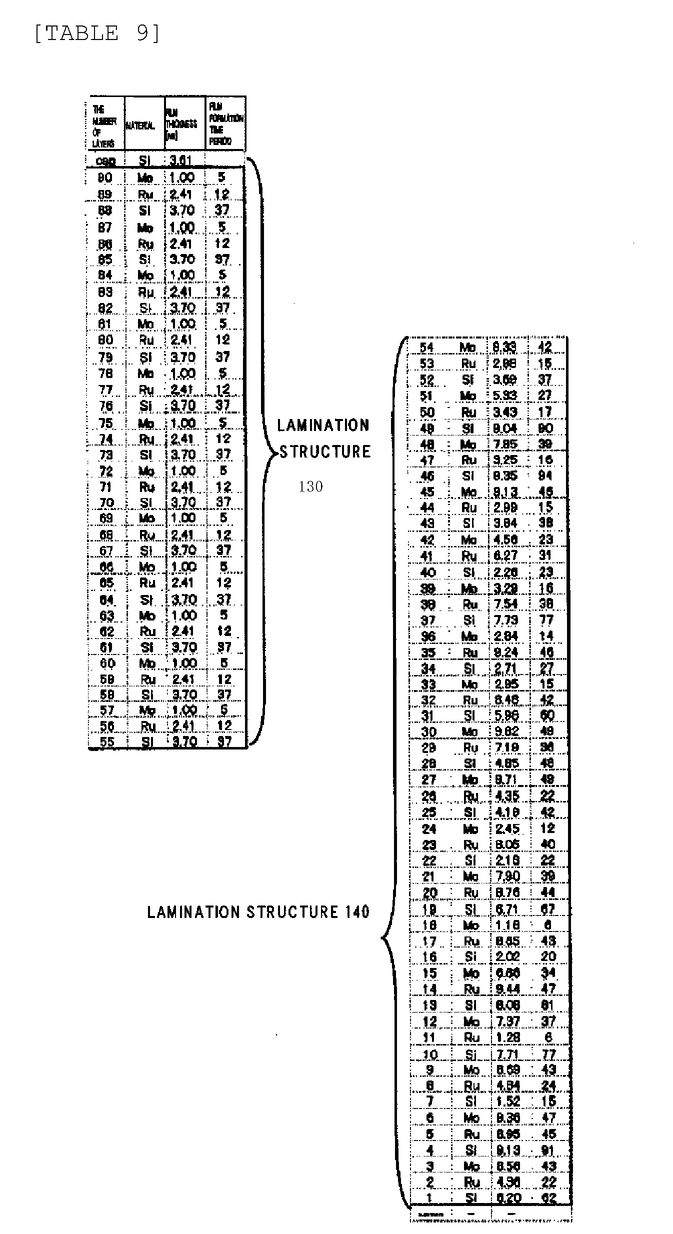

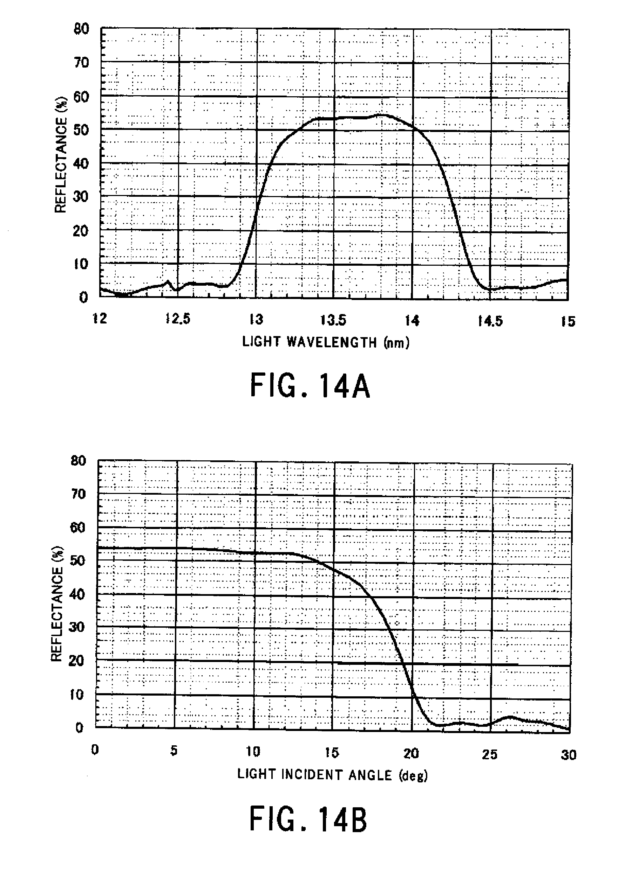

FIG. 2B is a schematic view of the multilayer mirror. FIG. 14A shows a wavelength reflection characteristic. FIG. 14B shows an angular reflection characteristic. The reflectance is good enough to maintain 50% or greater in a wave range between 13.3 nm and 14.0 nm and up to an incident angle of 14°. It is understood from FIG. 14A that the wave range that provides the reflectance of 50% or greater increases by 0.1 nm in comparison with CB in FIG. 4A. It is understood from FIG. 14B that the angular range that provides the reflectance of 50% or greater increases by 5° in comparison with C in FIG. 4B.

### TENTH EMBODIMENT

A multilayer mirror is produced in a similar manner to the comparative example 2 so that the peak wavelength is 13.5 nm to the incident angle of 0°. The multilayer film 120A has 121 layers that include the lamination structure 140A having 72 layers on the substrate 110, the lamination structure 130A having 48 layers on the lamination structure 140A, and a Si cap layer on the lamination structure 130A. Table 10 indicates details of each film thickness, and the film formation time period. The film thickness ranges are preferably 0.5 nm ≤ Si ≤ 10 nm, 0.5 nm ≤ Mo ≤ 10 nm, 0.5 nm ≤ Ru ≤ 10 nm, and 0.5 nm ≤ Rh ≤ 10 nm. The film formation time data is input in the computer 912.

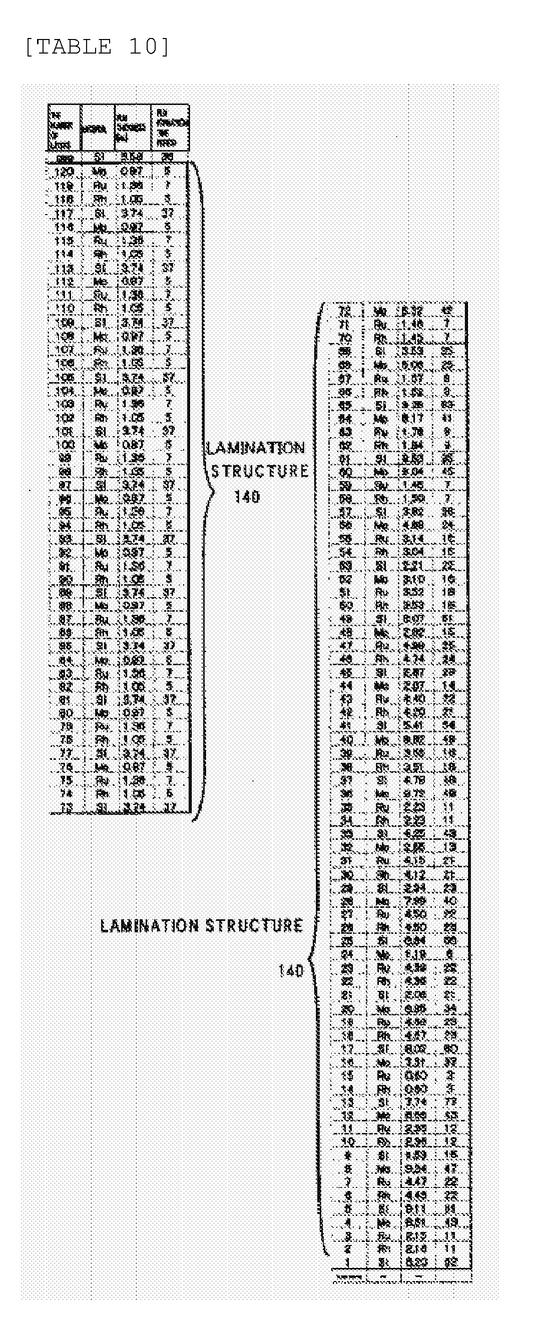

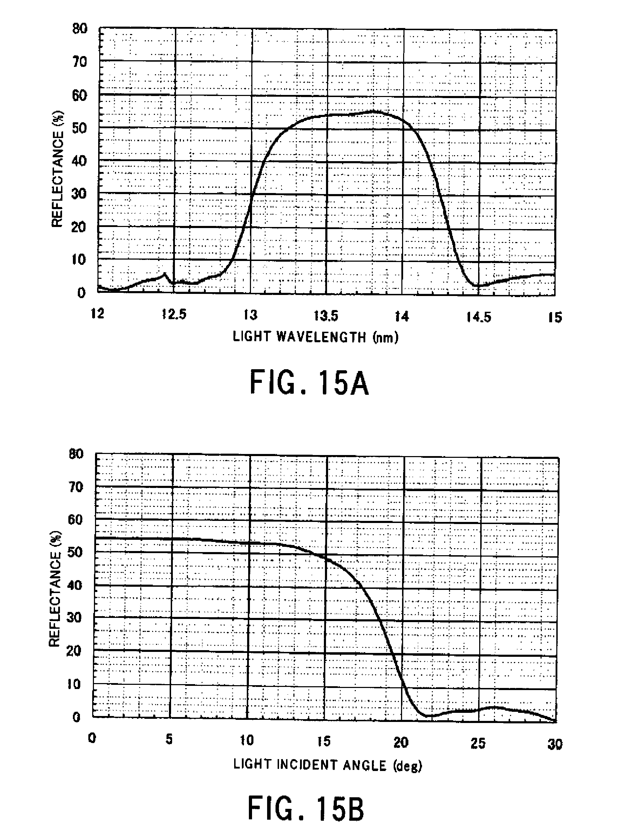

FIG. 2B is a schematic view of the multilayer mirror. FIG. 15A shows a wavelength reflection characteristic. FIG. 15B shows an angular reflection characteristic. The reflectance is good enough to maintain 50% or greater in a wave range between 13.3 nm and 14.0 nm and up to an incident angle of 14°. It is understood from FIG. 14A that the wave range that provides the reflectance of 50% or greater increases by 0.1 nm in comparison with CB in FIG. 4A. It is understood from FIG. 14B that the angular range that provides the reflectance of 50% or greater increases by 5° in comparison with C in FIG. 4B.

This embodiment can provide a multilayer film having a reflectance of 30% or greater to the light with an incident angle of 0° in a wave range between 13.1 nm and 14.2 nm, and a reflectance of 30% or greater to the light with an incident angle range between 0° and 17° and a wavelength of 13.5 nm. This embodiment can provide a multilayer film having a reflectance of 50% or greater to the light with an incident angle of 0° in a wave range between 13.3 nm and 14.0 nm, and a reflectance of 50% or greater to the light with an incident angle range between 0° and 14° and a wavelength of 13.5 nm.

### ELEVENTH EMBODIMENT

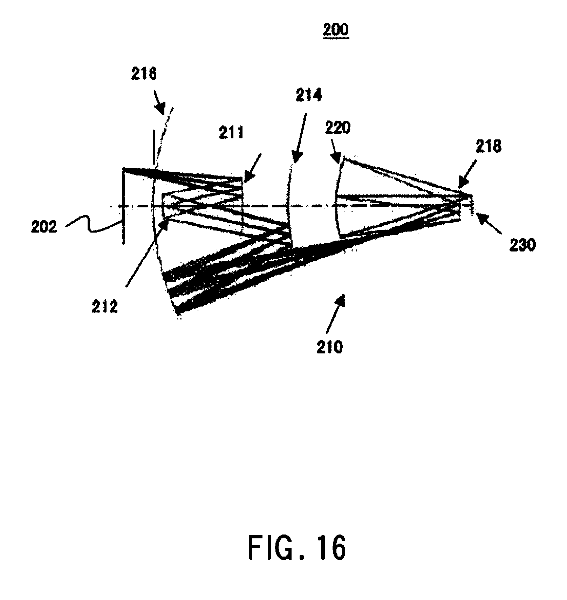

FIG. 16 shows a projection exposure apparatus 200 that uses a mirror produced in accordance with one of the above first to tenth embodiments. The exposure apparatus 200 transfers a pattern of a reflection mask 202 onto a substrate 230 via a catoptric reduction projection optical system 210 that includes mirrors 211 to 220. Thereby, a resist pattern with a size of 0.025 µm can be obtained from a pattern of 0.1 µm of the mask 202. The reduction ratio and wavelength are not limited to those in this embodiment. This is true of the resist. The optical system is not limited to that shown in FIG. 16, and the inventive optical element is applicable to an illumination optical system and a reflection mask.

The projection optical system 210 can use the conventional comparative example 1 or 2 for the mirrors 211, 212, 216 and 220 having a narrow light incident angle distribution range within 5°, and one of the first to tenth embodiments for the mirrors 214 and 218 having a wide light incident angle distribution range of 5° or greater.

The multilayer mirror of this embodiment can provide a wider wave range by about 17% and a wider light incident angular range by about 30% than the conventional mirror for the reflectance of 50 % or greater.

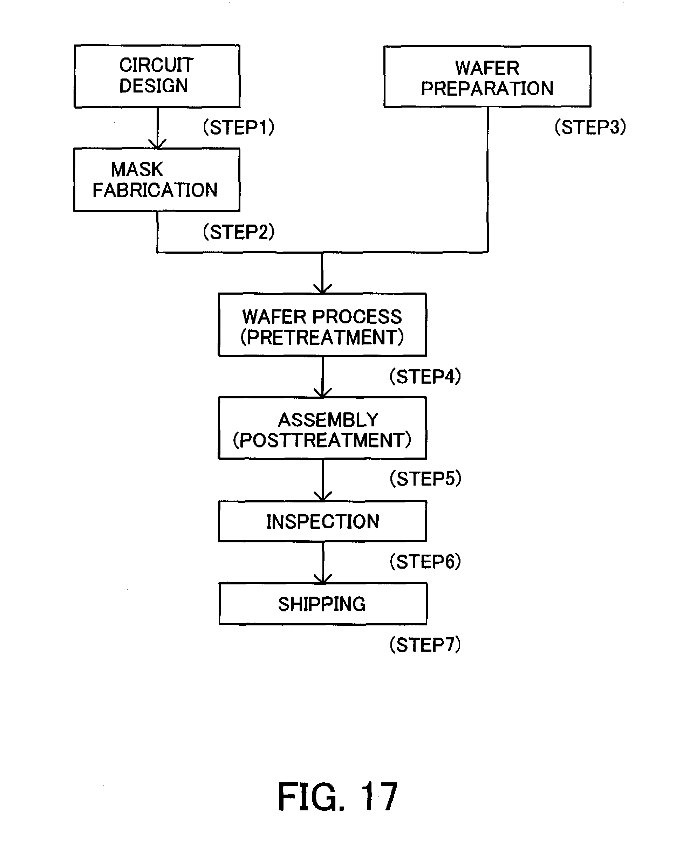

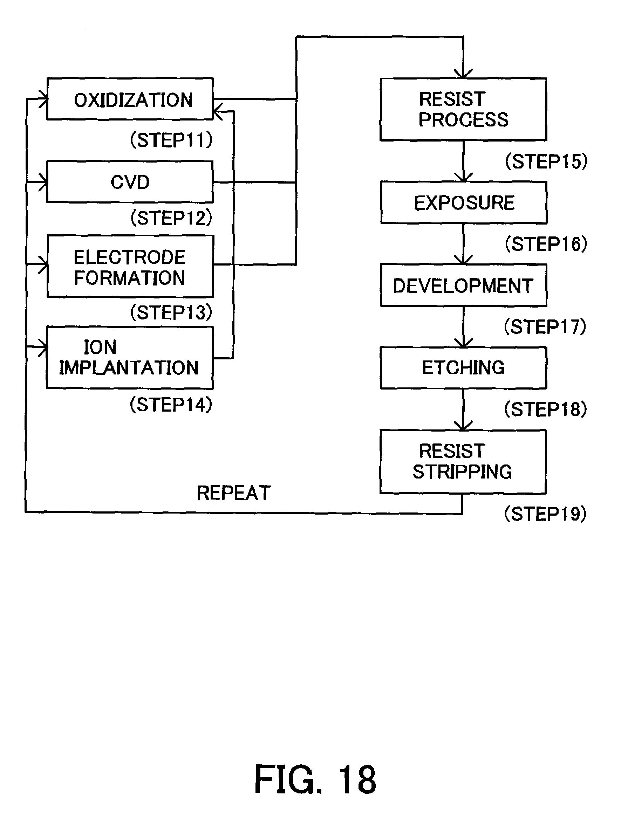

Referring now to FIGs. 17 and 18, a description will now be given of an embodiment of a device manufacturing method using the exposure apparatus 200. FIG. 17 is a flowchart for explaining a fabrication of devices (i.e., semiconductor chips such as IC and LSI, LCDs, CCDs, etc.). Here, a description will be given of a fabrication of a semiconductor chip as an example. Step 1 (circuit design) designs a semiconductor device circuit. Step 2 (mask fabrication) forms a mask having a designed circuit pattern. Step 3 (wafer preparation) manufactures a wafer using materials such as silicon. Step 4 (wafer process), which is referred to as a pretreatment, forms actual circuitry on the wafer through photolithography using the mask and wafer. Step 5 (assembly), which is also referred to as a posttreatment, forms into a semiconductor chip the wafer formed in Step 4 and includes an assembly step (e.g., dicing, bonding), a packaging step (chip sealing), and the like. Step 6 (inspection) performs various tests for the semiconductor device made in Step 5, such as a validity test and a durability test. Through these steps, a semiconductor device is finished and shipped (Step 7).

FIG. 18 is a detailed flowchart of the wafer process in Step 4 shown in FIG. 17. Step 11 (oxidation) oxidizes the wafer's surface. Step 12 (CVD) forms an insulating film on the wafer's surface. Step 13 (electrode formation) forms electrodes on the wafer by vapor disposition and the like. Step 14 (ion implantation) implants ions into the wafer. Step 15 (resist process) applies a photosensitive material onto the wafer. Step 16 (exposure) uses the exposure apparatus 200 to expose a mask pattern onto the wafer. Step 17 (development) develops the exposed wafer. Step 18 (etching) etches parts other than a developed resist image. Step 19 (resist stripping) removes disused resist after etching. These steps are repeated, and multilayer circuit patterns are formed on the wafer. This device manufacturing method can manufacture, with good throughput, higher quality devices, such as a semiconductor device, an LCD device, an imaging device (a CCD etc.), and a thin-film magnetic head, than ever, since a wide incident angle range is available for exposure. Thus, the device manufacturing method that uses the exposure apparatus 200, and its (final and intermediate) resultant products also constitute one aspect of the present invention.

Further, the present invention is not limited to these preferred embodiments, and various variations and modifications may be made without departing from the scope of the present invention.
A catoptric optical element includes a multilayer film for improving a reflectance to a light. The multilayer film includes a first lamination structure including plural basic lamination elements, each basic lamination element having two types of materials in each layer, each of the two types of materials having a constant thickness in each basic lamination element, the first lamination structure having a constant periodic length where one periodic length is defined as a thickness of each basic lamination element, and a second lamination structure alternately layering the two types of materials, wherein each of the two types of materials has a non-constant thickness, or the second lamination structure has a non-constant periodic length.

## Claims

1. A catoptric optical element comprising a multilayer film for improving a reflectance to a light, said multilayer film including a first lamination structure including plural basic lamination elements, each basic lamination element (131) having two types of materials (132, 134) in each layer, each of the two types of materials having a constant thickness in each basic lamination element, said first lamination structure having a constant periodic length where one periodic length is defined as a thickness of each basic lamination element, **characterized in that**:
said multilayer film further includes a second lamination structure alternately layering the two types of materials (142, 144), wherein each of the two types of materials has a non-constant thickness, or the second lamination structure has a non-constant periodic length.

2. A catoptric optical element according to claim 1, further comprising another layer (136, 146) made of a material that is different from the two types of materials and arranged between the two types of materials.

3. A catoptric optical element according to claim 2, wherein the material of the other layer has a primary ingredient selected from B, C, Ru, Rh, Li, Pd and a compound of B, C, Ru, Rh, Li and Pd.

4. A catoptric optical element according to claim 1, wherein the first lamination structure includes two types of lamination structures (130B, 130C) having different periodic lengths.

5. A catoptric optical element according to claim 1, wherein said multilayer film includes, in order from a substrate side, the second lamination structure, and the first lamination structure.

6. A catoptric optical element according to claim 1, wherein said multilayer film has a reflectance of 30% or greater to the light with an incident angle of 0° in a wave range between 13.1 nm and 14.2 nm, and a reflectance of 30% or greater to the light with an incident angle range between 0° and 17° and a wavelength of 13.5 nm.

7. A catoptric optical element according to claim 1, wherein said multilayer film has a reflectance of 50% or greater to the light with an incident angle of 0° in a wave range between 13.3 nm and 14.0 nm, and a reflectance of 50% or greater to the light with an incident angle range between 0° and 14° and a wavelength of 13.5 nm.

8. An exposure apparatus (200) comprising an optical element (214, 218) according to any one of claims 1 to 6 used to expose a mask pattern onto a plate.

9. A device manufacturing method comprising:
exposing a plate (230) using an exposure apparatus (200) that includes an optical element (214, 218) any one of claims 1 to 7; and
developing the plate that has been exposed.
